# EUROPEAN PATENT SPECIFICATION

(11) **EP 4 071 774 B1**
(45) Date of publication and mention of the grant of the patent: **19.06.2024**
(21) Application number: 22166864.3
(22) Date of filing: 06.04.2022
(51) Int. Cl.: H01F 27/28, H01F 27/30, H05K 1/16

(54) **INTEGRATED MAGNETIC COMPONENT, TRANSFORMER, AND POWER SYSTEM**
INTEGRIERTER MAGNETISCHER BESTANDTEIL, TRANSFORMATOR UND LEISTUNGSSYSTEM
COMPOSANT MAGNÉTIQUE INTÉGRÉ, TRANSFORMATEUR ET SYSTÈME D'ALIMENTATION

(30) Priority: 08.04.2021 CN 202110377397
(43) Date of publication of application: 12.10.2022
(73) Proprietor: Huawei Digital Power Technologies Co., Ltd., Shenzhen, 518043 (CN)
(72) Inventor: YU, Peng, Shenzhen, 518129 (CN); LIU, Yue, Jiangsu, 211106 (CN)
(74) Representative: Goddar, Heinz J.

(56) References cited:
- US-A1- 2018 226 182
- US-A1- 2019 043 660
- US-A1- 2020 211 756

## Description

### TECHNICAL FIELD

This application relates to the field of power electronics technologies, and in particular, to an integrated magnetic component, a transformer, and a power system.

### BACKGROUND

Currently, in the power supply field, there is an increasingly high requirement for a volume of a magnetic component. To be specific, a smallest possible size of the magnetic component is expected, so that a volume of an entire power supply can be reduced. Therefore, currently, many magnetic members are implemented by a planar power component with a PCB winding. For example, a transformer with a single magnetic pillar is decomposed into transformers with a plurality of magnetic pillars, so that a difficulty in implementing a winding of the transformer can be effectively reduced, to better adapt to an application scenario with a high-voltage input and a low-voltage and large-current output.

In an integrated magnetic component with a plurality of magnetic pillars, generally, a quantity of layers of printed circuit board (PCB, Printed Circuit Board) windings is an even number, and even-number layers of PCB windings are sleeved on a single magnetic pillar. For example, if there are a total of eight turns of PCB windings on a single magnetic pillar, and there are four layers of PCB windings, each layer of PCB winding includes two turns on average. Currently, only an integer quantity of turns can be disposed on each layer of PCB winding. Therefore, when a total quantity of turns of PCB windings on a single magnetic pillar is an odd number, the odd-number turns cannot be evenly allocated to the even-number layers of PCB windings. For example, there are a total of nine turns of PCB windings on a single magnetic pillar, and there are six layers of PCB windings. If the turns are to be evenly distributed, 1.5 turns of PCB windings need to be disposed on each layer. However, currently, integer turns of PCB windings are disposed on each layer, and therefore, distribution of fractional turns of PCB windings cannot be implemented.

If the PCB windings are unevenly distributed between layers of PCB circuit boards, a loss is increased. US 2019/043660 A1 describes a magnetic component comprising: a magnetic core comprising an upper magnetic core portion, a lower magnetic core portion, and four core columns; a first winding wound around any two core columns which form a first closed magnetic circuit with the upper and lower magnetic core portions therebetween; and a second winding wound around remaining two core columns which form a second closed magnetic circuit with the upper and lower magnetic core portions therebetween. A sum of an AC flux peak-peak value within single core column of the first closed magnetic circuit, and an AC flux peak-peak value within single core column of the second closed magnetic circuit is larger than not only an AC flux peak-peak value within the upper magnetic core portion, but also an AC flux peak-peak value within the lower magnetic core portion. The first winding and the second winding are not connected in series directly. US 2018/226182 A1 describes a matrix transformer for large voltage step-down, high current applications. The transformer has a unitary magnetic core structure featuring sheets of magnetic material and a two-dimensional array of pillars on which windings, oriented in opposite directions on pillars that are adjacent in orthogonal directions, can be formed or placed comprising metallization on or embedded in a printed circuit board (PCB) structure.
US 2020/211756 A1 describes a magnetic unit, including: a magnetic core and a winding, the magnetic core includes Q magnetic legs arranged in a row, where Q is a natural number and Q≥2. and the winding includes a first winding and a second winding, where the first winding is magnetically coupled with the second winding, and the first winding is wound around the Q magnetic legs while the second winding is wound around the Q magnetic legs. The first winding between any two adjacent magnetic legs is generally symmetrically disposed at both sides of the symmetric plane between the any two adjacent magnetic legs, thereby the magnetomotive force (MMF) distribution between any two adjacent magnetic legs is uniform.

### SUMMARY

To resolve the foregoing technical problems, this application provides an integrated magnetic component, a transformer, and a power system, so that odd-number turns of PCB windings or fractional turns of PCB windings can be evenly distributed on layers. The invention is defined by the independent claims. Advantageous embodiments of the invention are given by the dependent claims.

### BRIEF DESCRIPTION OF DRAWINGS

FIG. 1 is a schematic diagram of a circuit of a transformer;
FIG. 2 is a schematic diagram of an ER-type magnetic core;
FIG. 3 is a schematic diagram of a winding principle according to an embodiment of this application;
FIG. 4 is a schematic diagram of side-by-side placement of two ER-type magnetic cores according to an example of this application (not according to the claims);
FIG. 5 is a schematic diagram of an integrated magnetic core according to an embodiment of this application, but the PCB winding of Fig. 5 is not according to the claims;
FIG. 6 is a schematic diagram of a first layer when there is 0.5 turn on a single layer on a single magnetic pillar according to an embodiment of this application;
FIG. 7 is a schematic diagram of a second layer when there is 0.5 turn on a single layer on a single magnetic pillar according to an embodiment of this application;
FIG. 8 is a schematic diagram of a first layer when there are 1.5 turns on a single layer on a single magnetic pillar according to an embodiment of this application;
FIG. 9 is a schematic diagram of a second layer when there are 1.5 turns on a single layer on a single magnetic pillar according to an embodiment of this application;
FIG. 10 is a schematic diagram of a first layer when there are 2.5 turns on a single layer on a single magnetic pillar according to an embodiment of this application;
FIG. 11 is a schematic diagram of a second layer when there are 2.5 turns on a single layer on a single magnetic pillar according to an embodiment of this application;
FIG. 12A is a solid figure of four magnetic pillars according to an embodiment of this application;
FIG. 12B is a schematic diagram showing that nine turns are wound around a single magnetic pillar according to an embodiment of this application;
FIG. 12C is a schematic diagram of winding for a PCB transformer according to an embodiment of this application;
FIG. 13A is a schematic diagram of a first layer when there is 0.25 turn on a single layer on a single magnetic pillar according to an embodiment of this application;
FIG. 13B is a schematic diagram of a second layer when there is 0.25 turn on a single layer on a single magnetic pillar according to an embodiment of this application;
FIG. 14 is a schematic diagram of a first layer when there is 0.75 turn on a single layer on a single magnetic pillar according to an embodiment of this application;
FIG. 15 is a schematic diagram of a second layer when there is 0.75 turn on a single layer on a single magnetic pillar according to an embodiment of this application;
FIG. 16 is a schematic diagram of a transformer according to an embodiment of this application; and
FIG. 17 is a schematic diagram of a power system according to an embodiment of this application.

### DESCRIPTION OF EMBODIMENTS

The following describes the technical solutions in embodiments of this application with reference to accompanying drawings in embodiments of this application.

The following terms "first", "second", and the like are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In this application, it should be noted that the term "connection" should be understood in a broad sense unless otherwise expressly specified and limited. For example, the "connection" may be a fixed connection, may be a detachable connection, may be an integral connection; may be a direct connection, or may be an indirect connection implemented by using a medium. In addition, the term "coupled" may be a manner of implementing an electrical connection for signal transmission. The "coupling" may be a direct electrical connection, or may be an indirect electrical connection through an intermediate medium.

Embodiments of this application relate to an integrated magnetic component. The integrated magnetic component may be used as an inductor. For example, the integrated magnetic component is applied to a power conversion circuit, and the power conversion circuit may be a boost conversion circuit, or may be a buck conversion circuit. In addition, the inductor may also be applied to a filtering circuit or a resonance circuit. In addition, the integrated magnetic component may alternatively be used as a transformer, and the integrated magnetic component includes a primary-side winding and a secondary-side winding when being used as a transformer. A specific application scenario of the transformer is not limited in embodiments of this application, for example, the transformer may be applied to a power system. A specific application scenario of the power system is not limited in embodiments of this application, for example, an adapter of a mobile phone, a vehicle-mounted power supply, a power supply for a data center, a power supply for a server, or a power supply for a base station.

To enable a person skilled in the art to better understand the technical solutions provided in embodiments of this application, a scenario in which the integrated magnetic component provided in embodiments of this application is applied to a transformer is used as an example below for description.

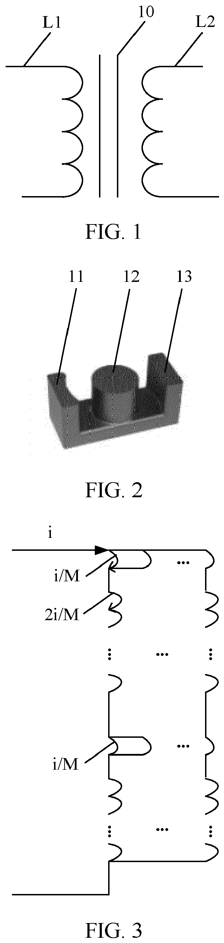

FIG. 1 is a schematic diagram of a circuit of a transformer.

Generally, the transformer includes a magnetic core 10, a primary-side winding L1, and a secondary-side winding L2. For example, the primary-side winding L1 is connected to a power supply, a current in the primary-side winding L1 generates an alternating magnetic field in the magnetic core 10, and the alternating magnetic field senses a current in the secondary-side winding L2, so that energy is transferred from the primary-side winding L1 of the transformer to the secondary-side winding L2.

Currently, there is an increasingly high requirement for a volume of the power supply, but a volume of a conventional inductor or transformer is relatively large. Therefore, the volume of the power supply cannot be miniaturized. To reduce the volume of the inductor or transformer, a PCB winding, that is, a planar PCB winding, is currently used, and corresponds to a PCB transformer. The PCB transformer includes a magnetic core and a PCB winding. The PCB winding means that copper is coated on a circuit board, the copper is used as a coil, turns are insulated from each other, and a hole is punctured on the circuit board, so that a magnetic pillar of the magnetic core can pass through; in other words, the PCB winding is sleeved on the magnetic pillar of the magnetic core. Generally, even-number layers of PCB windings are included, and the even-number layers of PCB windings are all sleeved on the magnetic pillar. There are a plurality of forms for implementing the magnetic core. A specific structure of the magnetic core is not limited in this embodiment of this application, and any magnetic core including two or four magnetic pillars can be used, for example, an ER-type magnetic core and an EI-type magnetic core. Not according to the claims, a magnetic core including more magnetic pillars such as six magnetic pillars or eight magnetic pillars may be alternatively used.

For intuitive understanding, a structure of a magnetic core is described below with reference to FIG. 2.

FIG. 2 is a schematic diagram of an ER-type magnetic core.

The ER-type magnetic core includes two side pillars: a first side pillar 11 and a second side pillar 13, and further includes one winding pillar 12. The winding pillar 12 is also referred to as a magnetic pillar. In an actual product, a PCB winding is sleeved on the winding pillar 12.

Generally, there are even-number layers of PCB windings. Therefore, odd-number turns or fractional turns of windings cannot be evenly allocated to even-number layers. When the windings cannot be evenly allocated to all layers of PCBs, currents are not uniformly distributed in the PCB windings, and consequently, a loss is increased.

To resolve the foregoing technical problems, this application provides an integrated magnetic component. The integrated magnetic component includes M magnetic pillars, where M is 2 or 4. A PCB winding is designed to divide a current path into M paths around a plurality of magnetic pillars, and then two magnetic pillars are one group. Current paths around every two magnetic pillars are converged, and then separated, and then converged, and such a cycle continues. A quantity of cycles is not limited. Finally, current paths around all magnetic pillars are converged, so that fractional turns of PCB windings can be wound on a single layer on a single magnetic pillar. Because there are even-number layers of PCB windings, odd-number turns or fractional turns of PCB windings can be allocated to even-number layers, so that currents are uniformly distributed on PCBs, a loss is reduced, and power conversion efficiency is improved.

In embodiments of this application, whether the M current paths obtained through division by the M magnetic pillars are evenly allocated is not limited. The M current paths may be evenly allocated, or may be unevenly allocated. For example, 1/2 of the M current paths are allocated to each of the two magnetic pillars. If the M current paths are unevenly allocated, 1/3 of the M current paths may be allocated to one of the two magnetic pillars, and 2/3 of the M current paths may be allocated to the other one in the two magnetic pillars. For easy implementation of a process, and for uniform magnetic flux on the magnetic pillars and uniform currents in the PCB windings, the current path may be evenly allocated by the M magnetic pillars, to reduce a loss of the PCB winding and improve power conversion efficiency. In the following embodiment, that the M magnetic pillars evenly divide the current path into M paths is used as an example for description.

### Embodiment of Integrated Magnetic Component

To enable a person skilled in the art to better understand the technical solutions provided in embodiments of this application, the following describes the technical solutions with reference to the accompanying drawings.

FIG. 3 is a schematic diagram of a winding principle according to an embodiment of this application.

An integrated magnetic component provided in this embodiment of this application includes an integrated magnetic core and a PCB winding, and there are even-number layers of PCB windings. The integrated magnetic core includes two or four magnetic pillars that are symmetrically distributed. Every two of the M magnetic pillars are one group; in other words, every two magnetic pillars are grouped into one group. On each layer of PCB winding, a current path is evenly divided into M paths around the M magnetic pillars. For example, a total current flowing into the PCB winding is i, and is evenly divided into M paths. In this case, a current flowing around each magnetic pillar by one turn is i/M; in other words, flowing around each magnetic pillar by one turn is equivalent to winding 1/M turns. Then, after every two of the M current paths are combined, a current obtained through combination flows around one magnetic pillar in each group of magnetic pillars by N turns. N is a positive integer. Because the two current paths are combined, a current obtained after a current obtained by combining the two paths flows around the magnetic pillar by one turn is 2i/M, a current obtained by combining the two paths flows around the magnetic pillar by N turns, this is equivalent to flowing around the magnetic pillar by 2N/M turns. Similarly, such a cycle continues. Then, the current flows around the other magnetic pillar in each group of magnetic pillars by N turns. Finally, for the case of M = 4, all current paths are combined. In this way, fractional turns are wound on each layer of PCB winding on a single magnetic pillar.

It should be understood that the PCB winding is usually a planar coil winding.

According to the integrated magnetic core provided in this embodiment of this application, odd-number turns or fractional turns can be designed on a single winding pillar, and fractional turns can be implemented on each layer of PCB on each winding pillar in a multi-magnetic pillar structure, so that not only a winding loss can be reduced, but also a structure of the magnetic core can be thinner and smaller.

There is a common point, namely, a first node, when a current flows into the PCB winding. Starting from the first node, coil ends of the PCB winding are separately independently wound around M winding pillars to generate M first-turn coils, a total current starting from the first node is i, and if the current is evenly divided into M paths, magnetomotive force of i/M is generated on each winding pillar. Then, two adjacent winding pillars are one group, and there is a total of M/2 groups. In each group, currents i/M on two winding pillars are converged at a second common point in the group, namely, a second node, and a current obtained through convergence is 2i/M, and then k turns are wound around one winding pillar in the group. Then, a winding is independently wound around each of two winding pillars in the group at the third node by one turn, and currents are converged at a fourth node in the group, and finally, currents from groups are converged at the fourth point and then flow out together.

That the integrated magnetic component includes two ER-type magnetic cores that are integrated is used as an example below to describe a principle of odd-number turns or fractional turns provided in embodiments of this application.

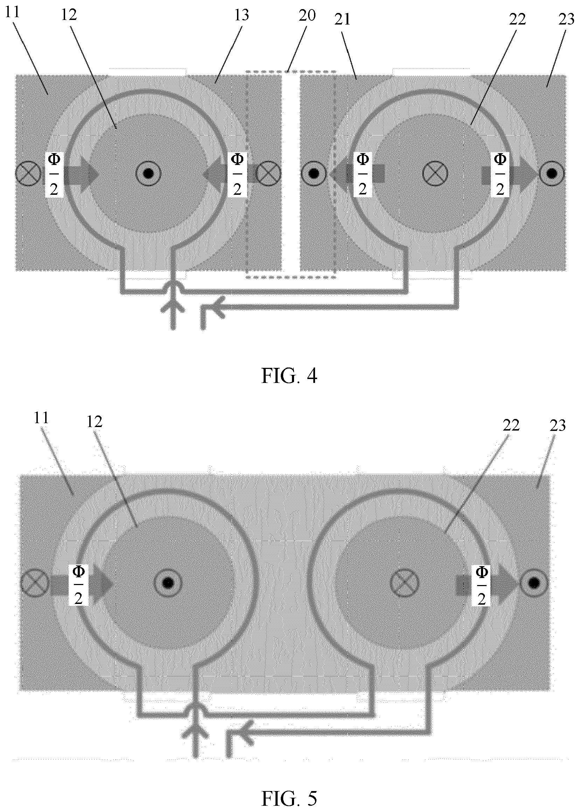

FIG. 4 is a schematic diagram of side-by-side placement of two ER-type magnetic cores according to an example of this application (not according to the claims).

FIG. 4 is a top view of side-by-side placement of two ER-type magnetic cores. For consistent description, a winding pillar in the ER-type magnetic core is referred to as a magnetic pillar below. A first ER-type magnetic core includes a first side pillar 11, a magnetic pillar 12, and a second side pillar 13, and a second ER-type magnetic core includes a first side pillar 21, a magnetic pillar 22, and a second side pillar 23.

It can be seen from a current flowing through a PCB winding in FIG. 4 that, a current in a PCB winding wound around the magnetic pillar 12 of the first ER-type magnetic core is counterclockwise, and a current in a PCB winding wound around the magnetic pillar 22 of the second ER-type magnetic core is clockwise. Therefore, a current direction in the magnetic pillar 12 and a current direction in the magnetic pillar 22 are opposite, so that a magnetic flux direction in the second side pillar 13 of the first ER-type magnetic core and a magnetic flux direction in the first side pillar 21 of the second ER-type magnetic core are opposite. Therefore, magnetic flux is offset from each other. When the two ER-type magnetic cores are integrated, two side pillars are omitted from an integrated magnetic core. As shown in FIG. 5, after the two ER-type magnetic cores are integrated, only the first side pillar 11 and the magnetic pillar 12 of the first ER-type magnetic core and the magnetic pillar 22 and the second side pillar 23 of the second ER-type magnetic core are left; in other words, the second side pillar 13 and the first side pillar 21 are saved.

It may be found by comparing FIG. 4 and FIG. 5 that, in the integrated magnetic core in FIG. 5, compared with a discrete magnetic core structure in FIG. 4, two side pillars are omitted from a structure of the integrated magnetic core, an occupied area is reduced, a volume of the magnetic core is also correspondingly reduced, and a higher integration degree of the magnetic cores leads to improvement of power density. In addition, a terminating loss of the integrated magnetic core is also correspondingly reduced, so that a loss of the PCB winding is reduced, and power conversion efficiency is improved. The magnetic core shown in FIG. 5 may be applied to a transformer. A primary-side winding and a secondary-side winding of the transformer may be wound in an interleaved manner. Interleaved winding means that the primary-side winding and the secondary-side winding of the transformer are wound at intervals. For example, one layer of PCB winding in the primary-side winding is wound, and then one layer of PCB winding in the secondary-side winding is wound; and such a cycle continues. In addition, alternatively, two layers of PCB windings in the primary-side winding may be wound, and then two layers of PCB windings in the secondary-side winding are wound; and such a cycle continues.

That the integrated magnetic core shown in FIG. 5 includes two magnetic pillars is used as an example to describe a principle of implementing fractional turns or odd-number turns in embodiments of this application.

First, an implementation of 0.5 turn is described by using two magnetic pillars as an example.

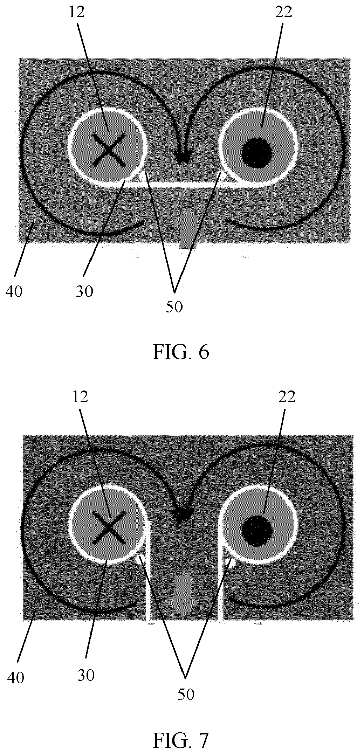

Refer to FIG. 6 and FIG. 7. FIG. 6 is a schematic diagram of a first layer when there is 0.5 turn on a single layer on a single magnetic pillar according to an embodiment of this application. FIG. 7 is a schematic diagram of a second layer when there is 0.5 turn on a single layer on a single magnetic pillar according to an embodiment of this application.

Each component part in FIG. 6 and FIG. 7 is first described. Two magnetic pillars: a magnetic pillar 12 and a magnetic pillar 22 are included. 30 around the magnetic pillar is an isolated area, and a PCB winding 40 is implemented by using metal. One turn of PCB winding is wound around the magnetic pillar, and a via hole 50 is disposed around each magnetic pillar. Locations of via holes on a first layer of PCB winding and a second layer of PCB winding correspond to each other. In other words, a via hole 50 in FIG. 6 exactly corresponds to a via hole 50 in FIG. 7.

It should be understood that a function of the via hole 50 is to allocate and converge currents between layers of PCB windings.

The current flows into a first layer of PCB in FIG. 6, and flows out of a second layer of PCB in FIG. 7. Current flowing directions can be seen from arrows in exact lower parts in FIG. 6 and FIG. 7.

In FIG. 6, when the current flows in, a current path is evenly divided into two paths by the two magnetic pillars 12 and 22. It can be learned from the isolated area that a current path in the magnetic pillar 12 on the left is clockwise, and a current path in the magnetic pillar 22 on the right is counterclockwise. Currents on both sides are combined into one current in the middle of the two magnetic pillars 12 and 22, that is, combined, and then the current enters, through the two via holes 50, the second layer of PCB shown in FIG. 7.

It should be understood that when PCB windings around the magnetic pillar 12 and the magnetic pillar 22 are designed to be asymmetric, the current path may not be evenly divided into two paths, but even if the current path is not evenly divided into two paths, after the two paths of currents are finally converged on the second layer shown in FIG. 7, the total inflow current in FIG. 6 is also obtained.

It can be seen from FIG. 7 that, because the isolated area is set, a flowing direction of a path of current that flows out of one of the two via holes is clockwise around the magnetic pillar 12, and a flowing direction of a path of current that flows out of the other one of the two via holes is counterclockwise around the magnetic pillar 22. Finally the two paths of currents are converged, that is, combined, and a current obtained through convergence flows out of the second layer of PCB winding shown in FIG. 7.

It can be learned from the foregoing analysis of FIG. 6 and FIG. 7 that, because one turn is wound around each magnetic pillar on each layer of PCB winding, and the total current that flows into the first layer of PCB winding is i, a current that flows through each layer on each magnetic pillar is i/2. Therefore, a quantity of turns of PCB windings on each magnetic pillar on each layer on the integrated magnetic component shown in FIG. 6 and FIG. 7 is 1/2, that is, 0.5 turn. Therefore, fractional turns are disposed on each layer of PCB winding. A sum of quantities of turns on two layers of PCB windings is 0.5+0.5=1. Because a quantity of turns of PCB windings is an even number, odd-number turns can be disposed.

FIG. 6 and FIG. 7 are each described by using an example in which only one turn of PCB winding is wound around each magnetic pillar. An implementation in which a plurality of turns of PCB windings are wound around each magnetic pillar is described below. When only one turn is wound around each magnetic pillar, a current flow into a first layer of PCB winding, and flows out of a second layer of PCB winding.

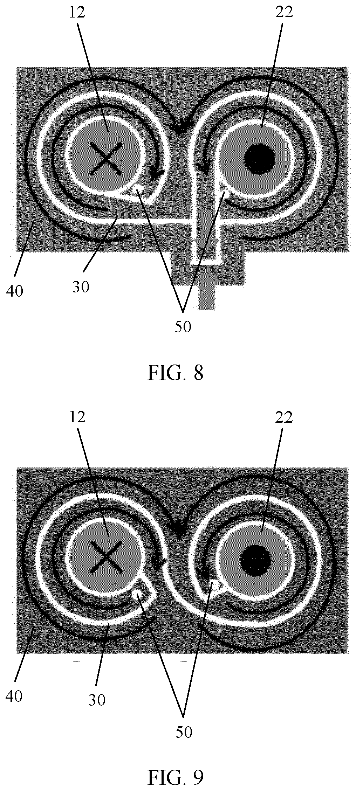

Refer to FIG. 8 and FIG. 9. FIG. 8 is a schematic diagram of a first layer when there are 1.5 turns on a single layer on a single magnetic pillar according to an embodiment of this application. FIG. 9 is a schematic diagram of a second layer when there are 1.5 turns on a single layer on a single magnetic pillar according to an embodiment of this application.

When a plurality of turns of PCB windings are wound on each magnetic pillar, a current flows in and flows out of a same layer of PCB winding.

It can be seen from FIG. 8 that, arrows showing current inflow and current outflow are both located on a first layer of PCB winding.

When the current flows in, a current path is divided into two paths due to an isolated area, and a current direction is clockwise around the magnetic pillar 12 and is counterclockwise around the magnetic pillar 22, that is, around an outermost turn of PCB winding. Then, the two paths of currents are converged. A current obtained through combination flows clockwise around the magnetic pillar 12 by one turn and enters a second layer of PCB winding through a via hole 50 on a lower right side of the magnetic pillar 12, that is, enters a second layer of PCB winding shown in FIG. 9. In FIG. 9, the current flows through an inner turn of the magnetic pillar 12 by one turn, and is then divided into two paths. A current direction is clockwise around the magnetic pillar 12 and counterclockwise around the magnetic pillar 22, that is, around an outermost turn of PCB winding. Then, the two paths of currents are converged, and a current obtained through combination flows counterclockwise around the magnetic pillar 22 by one turn, and flows, through a via hole 50 on a lower left part of the magnetic pillar 22, back to the first layer of PCB winding shown in FIG. 8. In FIG. 8, the current flows out after flowing counterclockwise around the magnetic pillar 22 by one turn.

With reference to FIG. 8 and FIG. 9, the magnetic pillar 12 on the left in FIG. 8 is used as an example. A total current is i, a current flowing through an outer turn of PCB winding of the magnetic pillar 12 is i/2, and a current flowing through an inner turn of PCB winding of the magnetic pillar 12 is i. Therefore, this is equivalent to that a quantity of turns of PCB windings wound around the magnetic pillar 12 is 0.5+1=1.5 turns. Similarly, 1.5 turns are also wound around the magnetic pillar 22. Therefore, in a manner of winding the PCB windings shown in FIG. 8 and FIG. 9, 1.5 turns can be wound on a single layer on a single magnetic pillar, and two layers of PCB windings are superposed, so that three turns can be implemented on a single magnetic pillar; in other words, odd-number turns are implemented.

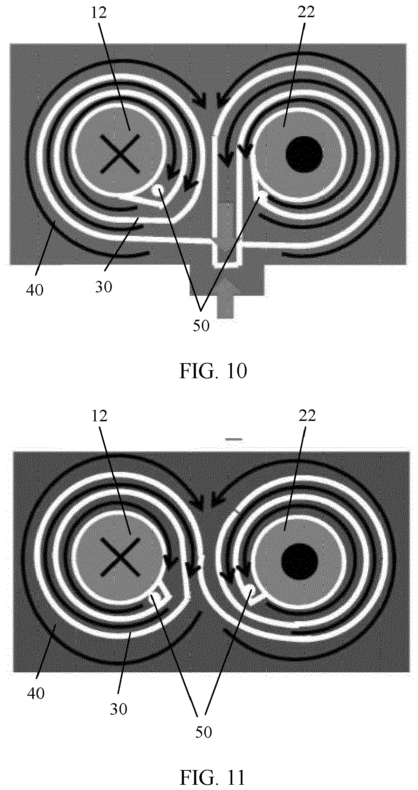

In the PCB windings shown in FIG. 8 and FIG. 9, a current flows in and flows out of a same layer of PCB. If a larger quantity of turns of PCB windings are to be wound on a single layer on a single magnetic pillar, several more turns, that is, several more turns, may be wound around a magnetic pillar after the currents are combined. 1.5 turns are implemented in FIG. 8 and FIG. 9. A case in which 2.5 turns of PCB windings are wound on a single layer on a single magnetic pillar is described below with reference to FIG. 10 and FIG. 11.

Refer to FIG. 10 and FIG. 11. FIG. 10 is a schematic diagram of a first layer when there are 2.5 turns on a single layer on a single magnetic pillar according to an embodiment of this application. FIG. 11 is a schematic diagram of a second layer when there are 2.5 turns on a single layer on a single magnetic pillar according to an embodiment of this application.

When a plurality of turns of PCB windings are wound on each magnetic pillar, a current flows in and flows out of a same layer of PCB winding.

It can be seen from FIG. 10 that, arrows showing current inflow and current outflow are both located on a first layer of PCB winding.

When the current flows in, a current path is divided into two paths due to an isolated area, and a current direction is clockwise around the magnetic pillar 12 and is counterclockwise around the magnetic pillar 22, that is, around an outermost turn of PCB winding. Then, the two paths of currents are converged. A current obtained through combination flows clockwise around the magnetic pillar 12 by two turns and enters a second layer of PCB winding through a via hole 50 on a lower right side of the magnetic pillar 12, that is, enters a second layer of PCB winding shown in FIG. 11. In FIG. 11, the current flows through an inner turn of the magnetic pillar 12 by two turns, and is then divided into two paths. A current direction is clockwise around the magnetic pillar 12 and counterclockwise around the magnetic pillar 22, that is, around an outermost turn of PCB winding. Then, the two paths of currents are converged, and a current obtained through combination flows counterclockwise around the magnetic pillar 22 by two turns, and flows, through a via hole 50 on a lower left part of the magnetic pillar 22, back to the first layer of PCB winding shown in FIG. 10. In FIG. 10, the current flows out after flowing counterclockwise around the magnetic pillar 22 by two turns.

With reference to FIG. 10 and FIG. 11, the magnetic pillar 12 on the left in FIG. 10 is used as an example. A total current is i, a current flowing through an outer turn of PCB winding of the magnetic pillar 12 is i/2, a current flowing through an inner turn of PCB winding of the magnetic pillar 12 is i, and two turns are wound around the inner turn. Therefore, this is equivalent to that a quantity of turns of PCB windings wound around the magnetic pillar 12 is 0.5+2=2.5 turns. Similarly, 2.5 turns are also wound around the magnetic pillar 22. Therefore, in a manner of winding the PCB windings shown in FIG. 10 and FIG. 11, 2.5 turns can be wound on a single layer on a single magnetic pillar, and two layers of PCB windings are superposed, so that five turns can be implemented on a single magnetic pillar; in other words, odd-number turns are implemented.

It may be learned from the foregoing analysis with reference to FIG. 8 to FIG. 11 that fractional turns can be wound on a single layer in the foregoing manner of winding the PCB winding. If a larger quantity of turns of PCB windings are wound, only a quantity of turns wound around a single magnetic pillar after two paths of currents are combined needs to be increased. 2.5 turns are wound in FIG. 10. Similarly, if one more turn is wound around an inner turn of the magnetic pillar 12, a quantity of turns of PCB windings on a single layer on a single magnetic pillar is correspondingly 3.5. By analogy, if eight turns are wound around the inner turn of the magnetic pillar 12, a quantity of turns of PCB windings on a single layer on a single magnetic pillar is correspondingly 8.5. A quantity of windings wound on an inner turn of each magnetic pillar is not specifically limited in this embodiment of this application, and may be set based on a requirement. It should be understood that in this embodiment of this application, the inner turn is a turn other than a first turn in outer turns. Because a current flowing through the first turn in the outer turns is divided into two paths, that is, this is equivalent to winding 0.5 turn around the outer turn, and for the inner turn, two paths of currents are combined for winding. Therefore, this is equivalent to winding integer turns wound around the inner turn.

When a total quantity of turns of PCB windings is an odd number and a total quantity of layers is an even number, odd-number turns of PCB windings may be evenly allocated to the even-number layers, so that currents in the PCB windings are uniform, and a loss is reduced.

According to the technical solution provided in this embodiment of this application, fractional turns of PCB windings are implemented on a single layer based on the integrated magnetic core; in other words, a quantity of turns of PCB windings on a single magnetic pillar in a plurality of magnetic pillars is an odd number or a fraction. Because fractional turns can be implemented on a single layer, fractional turns of PCB windings can be evenly distributed on even-number layers; in other words, on layers of PCB windings, PCB windings on the winding pillars are symmetrical in structure.

When the integrated magnetic component is applied to a PCB transformer, a primary-side winding and a secondary-side winding may be wound in an interleaved manner, so that a coupling relationship between the primary-side winding and the secondary-side winding can be effectively improved, and leakage inductance is reduced. When the primary-side winding and the secondary-side winding are wounded in an interleaved manner, currents are distributed more uniformly, so that magnetomotive force of the transformer is distributed more uniformly. In addition, the primary-side winding and the secondary-side winding are wounded in an interleaved manner, so that a proximity effect between the primary-side winding and the secondary-side winding can be reduced, and alternating current impedance of the PCB winding can be reduced, so that a loss is reduced. In addition, PCB windings on magnetic pillars in this embodiment of this application are evenly and symmetrically distributed. Therefore, currents in windings connected in series, especially, in windings connected in parallel, are distributed more uniformly, so that a loss is reduced. Because the primary-side winding and the secondary-side winding of the PCB transformer are wound on different layers in an interleaved manner, the primary-side winding and the secondary-side winding may be simultaneously wound on a same magnetic pillar.

The integrated magnetic component described above by using two magnetic pillars as an example is particularly applicable to an application scenario of a low voltage and a large current. For example, the PCB transformer is applied to a power adapter of an electronic device. When the electronic device is a mobile phone, a large current may be charged to the mobile phone, so that a quick charging function is implemented. In the scenario of a low voltage and a large current, a matrix transformer structure in which primary-side windings are connected in series and secondary-side windings are connected in parallel is usually used for the PCB transformer. Because the secondary-side winding includes a plurality of windings connected in parallel, a current on a single winding is relatively small, so that local overheating can be effectively avoided.

According to the magnetic core obtained by integrating two ER-type magnetic cores provided in the foregoing embodiments of this application, current directions in PCB windings on two magnetic pillars are controlled to be opposite, so that magnetic flux directions in two adjacent side pillars of the two ER-type magnetic cores are opposite, and magnetic flux in two adjacent side pillars of the two ER-type magnetic cores can be offset. Therefore, two side pillars are omitted from the integrated magnetic core. In a case of not affecting magnetic flux distribution, integration of the magnetic cores leads to improvement of power density. In addition, when the magnetic core obtained by integrating the two ER-type magnetic cores is applied to the PCB transformer, because there are no two side pillars, the two magnetic pillars are not blocked by the side pillar, so that a terminating effect and a terminating loss can be reduced, and further electrical energy conversion efficiency is improved.

That the integrated magnetic core includes two magnetic pillars is used as an example for description above. The integrated magnetic core may alternatively include more magnetic pillars. Four magnetic pillars are used as an example to describe another implementation provided in embodiments of this application. When the integrated magnetic core includes a plurality of magnetic pillars, because a quantity of layers of PCBs is generally an even number, if a quantity of turns of PCB windings allocated to a single magnetic pillar is an odd number or a fraction, the PCB windings cannot be evenly and symmetrically distributed between the layers of PCBs. To resolve the foregoing problem, a method for winding fractional turns of windings based on the PCB winding is described below. On M magnetic pillars, current paths are split and combined, and then split and combined again, so that quantities of turns of PCBs on all the magnetic pillars are equal, and winding structures are symmetrical.

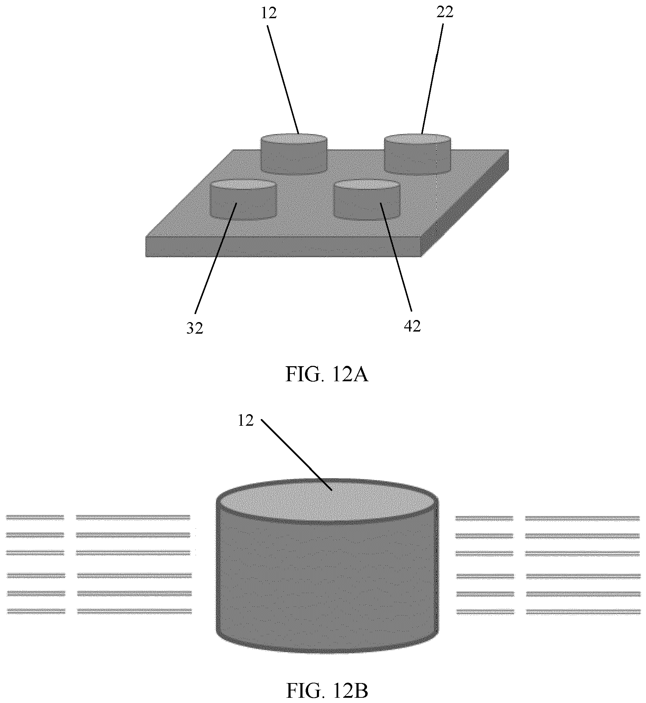

FIG. 12A is a solid figure of four magnetic pillars according to an embodiment of this application.

The four magnetic pillars are a first magnetic pillar 12, a second magnetic pillar 22, a third magnetic pillar 32, and a fourth magnetic pillar 42.

This embodiment is similar to the integrated magnetic core with two magnetic pillars described in the foregoing embodiment. The integrated magnetic core with two magnetic pillars may be obtained by integrating two ER-type magnetic cores. Similarly, the four magnetic pillars may be obtained by integrating four ER-type magnetic cores, the four magnetic pillars each correspond to one ER-type magnetic core, the first magnetic pillar 12 and the second magnetic pillar 22 in the four magnetic pillars are located in a first row, the third magnetic pillar 32 and the fourth magnetic pillar 42 are located in a second row, and the four magnetic pillars are bilaterally and transversely symmetrical. In other words, an integrated magnetic core includes four ER-type magnetic cores. The first magnetic pillar, the second magnetic pillar, the third magnetic pillar, and the fourth magnetic pillar are magnetic pillars of the four ER-type magnetic cores.

The first magnetic pillar 12 and the second magnetic pillar 22 are arranged in a first row, and a current direction in a PCB winding on the first magnetic pillar 12 and a current direction in a PCB winding on the second magnetic pillar 22 are opposite, so that magnetic flux of adjacent side pillars of two ER-type magnetic cores in the first row are offset.

The third magnetic pillar 32 and the fourth magnetic pillar 42 are arranged in a second row, and a current direction in a PCB winding on the third magnetic pillar 32 and a current direction in a PCB winding on the fourth magnetic pillar 42 are opposite, so that magnetic flux of adjacent side pillars of two ER-type magnetic cores in the second row are offset. For example, if nine turns of PCB windings need to be evenly wound on six layers, 1.5 turns of PCB windings are wound on each layer on average. FIG. 12B is a schematic diagram showing that nine turns of PCB windings are wound on six layers according to an embodiment of this application.

A single magnetic pillar is used as an example for description. A total of nine turns are wound on the magnetic pillar 12 and are wound on six layers, and 1.5 turns are wound on each layer on average. In this way, odd-number turns of PCB windings are evenly distributed on even-number layers.

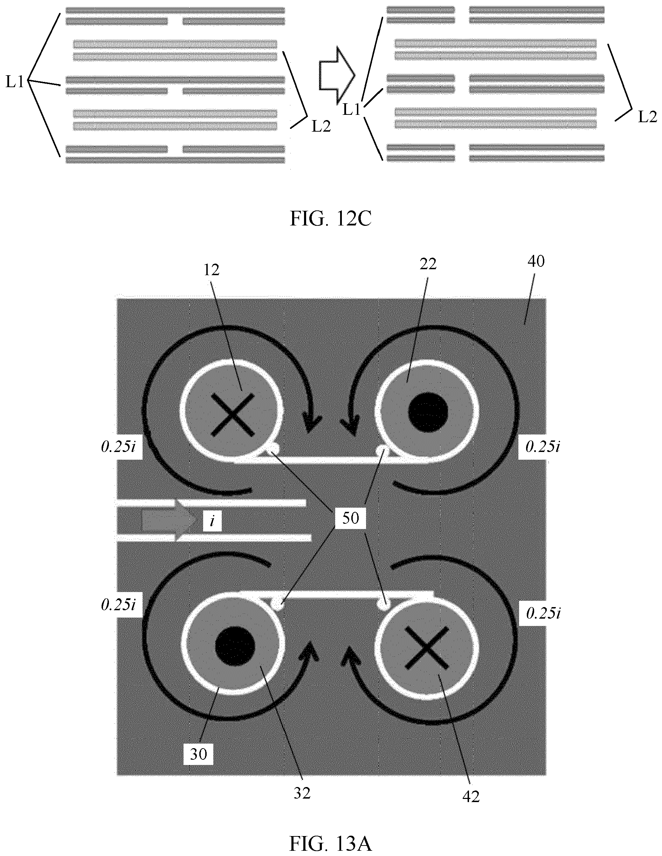

To better compare a winding difference between conventional integer turns and fractional turns provided in embodiments of this application, refer to FIG. 12C. FIG. 12C is a schematic diagram of winding for a PCB transformer according to an embodiment of this application.

An application scenario of the transformer is still used as an example. The transformer includes a primary-side winding and a secondary-side winding.

A left side shows a conventional winding manner. It can be seen from the figure that nine turns of conventional primary-side windings need to be wound on six layers of PCB windings, and therefore, there is one turn on a first layer, there are two turns on a second layer, there is one turn on a third layer, there are two turns on a fourth layer, there is one turn on a fifth layer, and there are two turns on a sixth layer. It can be seen that there is one turn on some layers and two turns on some layers. In this way, quantities of turns wound on all the layers are not uniform, and consequently, currents on windings are not uniform, and power consumption is relatively large.

A right side shows a method for winding a PCB winding in this embodiment of this application. If the transformer has a total of nine turns of primary-side windings that are to be wound on six layers of PCB windings, 1.5 turns are wound on each layer, so that quantities of turns on the six layers of PCB windings are equal and are uniformly distributed. Therefore, currents in all layers of PCB windings are more uniform, so that power consumption is relatively low, and power conversion efficiency of the transformer can be improved.

The integrated magnetic core described in the foregoing embodiment includes a plurality of magnetic cores, that is, two or four magnetic cores. The integrated magnetic core may also be referred to as a matrix magnetic core.

A manner for winding PCB windings on four magnetic pillars is described below with reference to the accompanying drawings. FIG. 12A is a solid figure of four magnetic pillars. The following figures are top views of four magnetic pillars.

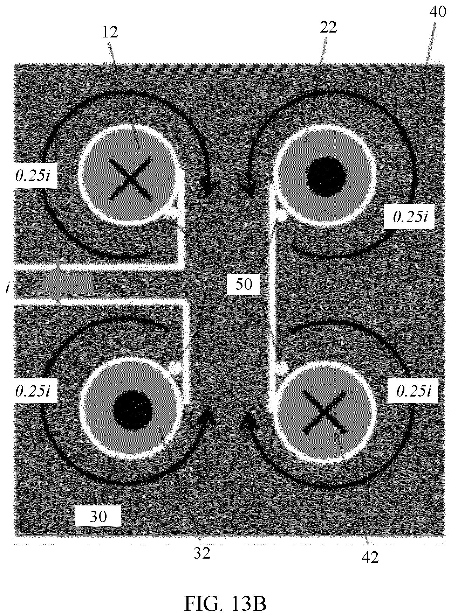

Refer to FIG. 13A and FIG. 13B. FIG. 13A is a schematic diagram of a first layer when there is 0.25 turn on a single layer on a single magnetic pillar according to an embodiment of this application. FIG. 13B is a schematic diagram of a second layer when there is 0.25 turn on a single layer on a single magnetic pillar according to an embodiment of this application.

In this embodiment of this application, four magnetic pillars are used as an example for description, namely, a magnetic pillar 12, a magnetic pillar 22, a magnetic pillar 32, and a magnetic pillar 42. The four magnetic pillars are symmetrically distributed, and spacings between two adjacent magnetic pillars are equal; in other words, central points of the four magnetic pillars may be four vertices of one square. Every two of the four magnetic pillars are one group. In FIG. 12, two magnetic pillars 12 and 22 in a first row are one group, and two magnetic pillars 32 and 42 in a second row are one group.

FIG. 13A shows a first layer of PCB winding. A current flows into the first layer of PCB winding, and flows out of a second layer of PCB winding shown in FIG. 13B.

That a total current is i is still used as an example for description. The total current i flows into the first layer of PCB winding, and is evenly divided into four parts by four magnetic pillars, that is, is divided into four paths. As shown in FIG. 13A, a current of 0.25i flows around the magnetic pillar 12 clockwise, a current of 0.25i flows around the magnetic pillar 22 counterclockwise, a current of 0.25i flows around the magnetic pillar 32 counterclockwise, and a current of 0.25i flows around the magnetic pillar 42 clockwise. The currents that flow around the magnetic pillar 12 and the magnetic pillar 22 are converged into a current of 0.5i, and the current of 0.5i flows through a via hole 50 into the second layer of PCB winding shown in FIG. 13B. Similarly, the currents that flow around the magnetic pillar 32 and the magnetic pillar 42 are converged into a current of 0.5i, and the current of 0.5i flows through a via hole 50 into the second layer of PCB winding shown in FIG. 13B.

It can be seen from FIG. 13B that, a current of 0.25i flows into each magnetic pillar through a via hole 50. A current in the magnetic pillar 12 and a current in the magnetic pillar 22 are converged into 0.5i, a current in the magnetic pillar 32 and a current in the magnetic pillar 42 are converged into 0.5i, and then the two paths of currents of 0.5i are converged into i that flows out of the second layer of PCB winding.

It can be learned from the foregoing analysis that, in the manner of winding the PCB winding shown in FIG. 13A and FIG. 13B, a manner of winding 0.25 turn of PCB winding on a single layer on a single magnetic pillar is implemented. Because there are even-number layers of PCB windings, for example, there are two layers of PCB windings, 0.5 turn, that is, a fractional turn, of PCB winding can be wound on a single magnetic pillar. If there are four layers of PCB windings, one turn can be wound on a single magnetic pillar.

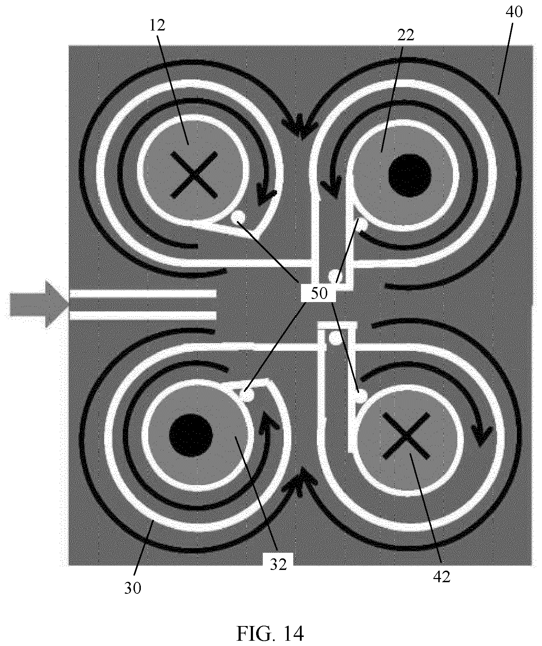

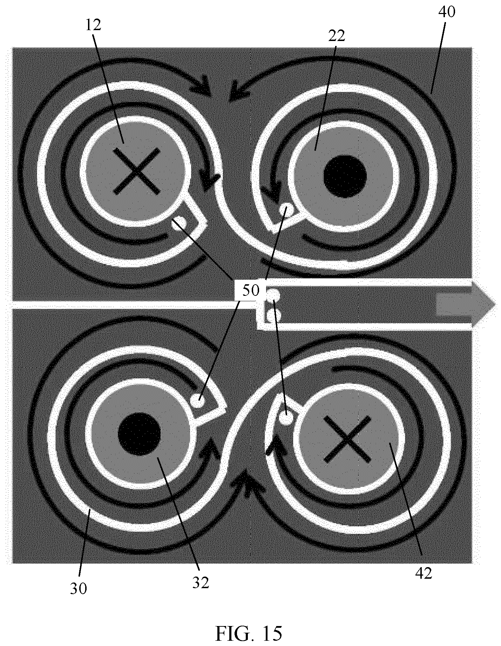

FIG. 13A and FIG. 13B are described by using an example in which one turn is wound around each magnetic pillar, and a current obtained by each magnetic pillar through equal division is 0.25i. Four magnetic pillars are still used as an example below for description with reference to FIG. 14 and FIG. 15. Two magnetic pillars are one group, currents around the two magnetic pillars are combined and then a current obtained through combination flows around one of the magnetic pillars by integer turns, and enters a second layer of PCB winding, and after flowing by integer turns again, the current is divided into two paths, and a current obtained by combining the two paths flows around the other magnetic pillar in one group by integer turns. In this way, 0.5N+0.25 turn is wound on a single layer on a single magnetic pillar. N+0.5 turns are wound on two layers of PCB windings, where N is a positive integer.

Refer to FIG. 14 and FIG. 15. FIG. 14 is a schematic diagram of a first layer when there is 0.75 turn on a single layer on a single magnetic pillar according to an embodiment of this application. FIG. 15 is a schematic diagram of a second layer when there is 0.75 turn on a single layer on a single magnetic pillar according to an embodiment of this application.

It can be seen from FIG. 14 that each magnetic pillar has two turns of PCB windings, and a current flows into a first layer of PCB winding and is evenly divided into four paths due to an isolated area, that is, is divided into four parts.

That a total current is i is still used as an example for description. The total current i flows into the first layer of PCB winding, and is evenly divided into four parts by four magnetic pillars, that is, is divided into four paths. As shown in FIG. 14, a current of 0.25i flows around the magnetic pillar 12 clockwise, a current of 0.25i flows around the magnetic pillar 22 counterclockwise, a current of 0.25i flows around the magnetic pillar 32 counterclockwise, and a current of 0.25i flows around the magnetic pillar 42 clockwise. The currents that flow around the magnetic pillar 12 and the magnetic pillar 22 are converged into a current of 0.5i, and the current of 0.5i flows around the magnetic pillar 12 by one turn, and then enters, through a via hole 50, a second layer of PCB winding shown in FIG. 15. Similarly, the currents that flow around the magnetic pillar 32 and the magnetic pillar 42 are converged into a current of 0.5i, and the current of 0.5i flows around the magnetic pillar 32 by one turn, and then enters, through a via hole 50, the second layer of PCB winding shown in FIG. 15.

It can be seen from FIG. 15 that the current of 0.5i that flows into the first layer of PCB winding flows around the magnetic pillar 12 by one turn, and is then divided into two paths, that is, 0.25i, and the two paths separately flow around the magnetic pillar 12 and the magnetic pillar 22 by one turn and are then converged into 0.5i; and the current of 0.5i flows around the magnetic pillar 22 by one turn, flows back to the first layer of PCB winding through a via hole 50 on a lower left side of the magnetic pillar 22, flows around the magnetic pillar 22 counterclockwise by one turn on the first layer of PCB winding, and flows into the second layer of PCB winding through a via hole 50. It should be understood that all via holes on the first layer of PCB winding are in one-to-one correspondence with via holes on the second layer of PCB winding.

Similarly, a current of 0.5i that flows into the first layer of PCB winding flows around the magnetic pillar 32 by one turn, and is then divided into two paths, that is, 0.25i, and the two paths separately flow around the magnetic pillar 32 and the magnetic pillar 42 by one turn and are then converged into 0.5i; and the current of 0.5i flows around the magnetic pillar 42 by one turn, flows back to the first layer of PCB winding through a via hole 50 near the magnetic pillar 42, flows around the magnetic pillar 42 counterclockwise by one turn on the first layer of PCB winding, and flows into the second layer of PCB winding through a via hole 50.

It can be learned from the foregoing analysis that, in the manner of winding the PCB winding shown in FIG. 14 and FIG. 15, 0.25+0.5 turn of PCB winding is wound on a single layer on a single magnetic pillar, so that a manner of winding 0.75 turn of PCB winding on a single layer on a single magnetic pillar is implemented. Because there are even-number layers of PCB windings, for example, there are two layers of PCB windings, 1.5 turns, that is, fractional turns, of windings can be wound on a single magnetic pillar. If there are four layers of PCB windings, three turns can be wound on a single magnetic pillar.

The foregoing embodiments are separately described by using examples in which an integrated magnetic core includes two magnetic pillars and four magnetic pillars. The quantity of magnetic pillars is 2 or 4. Not according to the claims, the quantity of magnetic pillars may alternatively be another quantity of magnetic pillars, for example, six or eight. A person skilled in the art may set, based on an actual quantity of layers and an actual quantity of turns of PCB windings, the quantity of magnetic pillars and a quantity of turns of PCB windings wound on each magnetic pillar. For PCB windings of a same quantity of turns, a height obtained after the PCB windings are wound on the two magnetic pillars is higher than a height obtained after the PCB windings are wound on the four magnetic pillars. Therefore, for a scenario in which there is a relatively high requirement for a thickness of a product, that is, for a scenario in which a thinnest possible thickness is expected and the product is relatively flat, a larger quantity of magnetic pillars may be disposed. For a scenario in which there is no relatively high requirement for a thickness of a product, a relatively small quantity of magnetic pillars may be used. For example, when the two magnetic pillars correspond to eight layers of PCB windings, the four magnetic pillars may correspond to four layers of PCB windings, and a quantity of layers of PCB windings may be reduced by half, so that a height of an entire integrated magnetic component is reduced.

### Embodiment of Transformer

Based on the integrated magnetic component provided in the foregoing embodiment, an embodiment of this application further provides a transformer, namely, a PCB transformer. The following describes the transformer in detail with reference to the accompanying drawings.

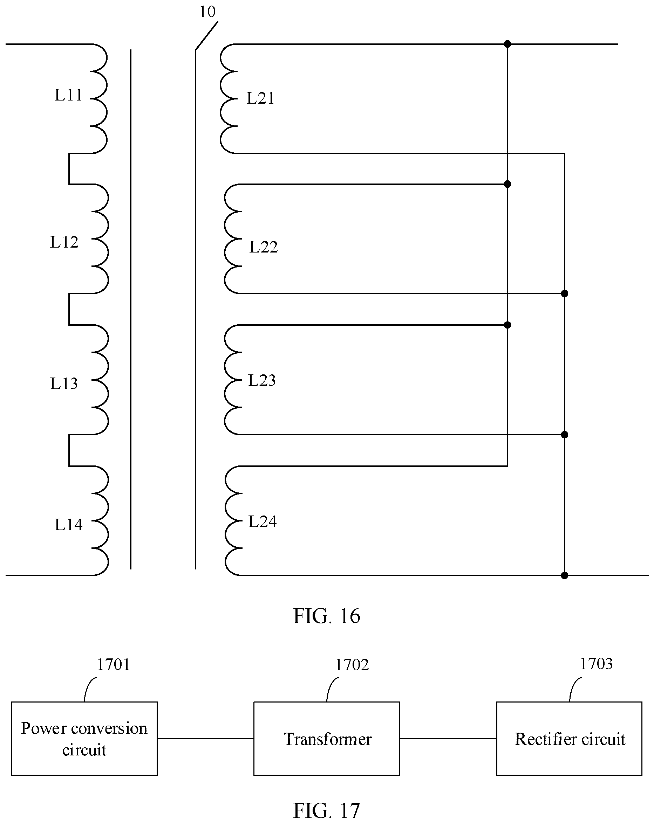

FIG. 16 is a schematic diagram of a transformer according to an embodiment of this application.

The transformer provided in this embodiment includes the integrated magnetic component described in the foregoing embodiment.

The transformer includes a primary-side winding and a secondary-side winding.

The primary-side winding includes a plurality of layers of PCB windings, and the secondary-side winding includes a plurality of layers of PCB windings.

The plurality of layers of PCB windings in the primary-side winding and the plurality of layers of PCB windings in the secondary-side winding are wound in an interleaved manner, and the interleaved winding is similar to a sandwich structure; in other words, the primary-side winding and the secondary-side winding are wound at intervals.

The interleaved winding in this embodiment of this application may be that one layer of primary-side winding is wound and then one layer of secondary-side winding is wound; in other words, interleaved winding is performed layer by layer. In addition, two layers of primary-side windings may be wound and then two layers of secondary-side windings are wound; in other words, interleaved winding is performed two layers by two layers. In other words, a first manner is: One layer of PCB winding in the primary-side winding is wound on the transformer, and one layer of PCB winding in the secondary-side winding is wound; and such a cycle continues. A second manner is: Two layers of PCB windings in the primary-side winding are wound on the transformer, and two layers of PCB windings in the secondary-side winding are wound; and such a cycle continues.

A via hole is disposed between two adjacent layers of PCB windings in the primary-side winding, and the via hole on the primary-side winding is used to connect two adjacent layers of PCB windings in series. A via hole is disposed between two adjacent layers of PCB windings in the secondary-side winding, and the via hole on the secondary-side winding is used to connect two adjacent layers of PCB windings in parallel. In addition, to connect secondary-side windings in parallel, the secondary-side windings may be connected in parallel by using a wire without using a via hole. This is not specifically limited in this embodiment of this application.

For the first winding manner, for example, a first layer is a primary-side winding, a second layer is a secondary-side winding, a third layer is a primary-side winding, and a fourth layer is a primary-side winding, and so on, because all layers of primary-side windings need to be connected, and all layers of secondary-side windings need to be connected, the primary-side winding on the first layer needs to be connected to the primary-side winding on the third layer, there needs to be a via hole between the first layer, the second layer, and the third layer, and a cable on the secondary-side winding on the second layer needs to avoid a via hole connecting the first layer and the third layer. Because the cable on the secondary-side winding on the second layer is lost if the via hole is to be avoided, the cable on the secondary-side winding is narrowed down, and consequently power consumption of the secondary-side winding is increased. Similarly, when the secondary-side winding on the second layer is connected to the secondary-side winding on the fourth layer, there needs to be a via hole that penetrates the second layer, the third layer, and the fourth layer. In other words, there needs to be a via hole on each layer, and a cable on a winding on each layer needs to be sacrificed to avoid the via hole. When there are a large quantity of via holes, a cabling design in which the via hole needs to be avoided on each layer is more complex and a greater loss is also caused.

To reduce a quantity of via holes, reduce a loss, and simplify a process, when two layers of windings of the second type of transformer are used as one group and are wound in an interleaved manner, for example, both the first layer and the second layer are two layers of primary -side windings, and both the third layer and the fourth layer are two layers of secondary-side windings. Such a cycle continues. Because the first layer and the second layer need to be connected in series, a via hole needs to be disposed between the first layer and the second layer; in other words, the first layer and the second layer are broken through. Because an electrical connection is not required between the primary-side winding and the secondary-side winding, a via hole does not need to be disposed between the second layer and the third layer. Similarly, both the third layer and the fourth layer are secondary-side windings, and need to be connected in parallel. Therefore, a via hole needs to be disposed between the third layer and the fourth layer; in other words, the third layer and the fourth layer are interconnected. In this way, the via hole is disposed between two adjacent layers of primary-side windings, and the via hole is disposed between two adjacent layers of secondary-side windings. In this way, a quantity of disposed via holes can be reduced, so that a quantity of cables disposed to avoid a penetrated via hole is reduced, a loss is reduced, and a process is relatively simple.

The transformer provided in this embodiment of this application includes the integrated magnetic component described in the foregoing embodiment. Therefore, advantages of the integrated magnetic component are also applicable to the transformer provided in this embodiment of this application; in other words, odd-number turns of PCB windings can be evenly distributed on even-number layers.

Details are not described herein again. In addition, because the primary-side winding and the secondary-side winding of the transformer provided in this embodiment of this application are wound in an interleaved manner, the primary-side winding and the secondary-side winding are evenly distributed, and magnetomotive force is uniformly distributed, and because the primary-side winding and the secondary-side winding are wound in an interleaved manner, alternating current impedance of the winding can be reduced, a loss can be reduced, and power conversion efficiency of the transformer can be improved.

According to the transformer provided in this embodiment, a plurality of layers of PCB windings included in the primary -side winding are connected in series, and a plurality of layers of PCB windings included in the secondary-side winding are connected in parallel.

In FIG. 16, an example in which the primary-side winding includes four windings connected in series and the secondary-side winding includes four windings connected in parallel is used for description. The primary-side winding and the secondary-side winding each are the PCB winding in the integrated magnetic component described in the foregoing embodiment.

The primary-side winding includes four windings L11, L12, L13, and L14 connected in series, and the secondary-side winding includes four windings L21, L22, L23, and L24 connected in parallel.

According to the transformer provided in this embodiment of this application, when the secondary-side winding includes a plurality of windings connected in parallel, the transformer is particularly applicable to a case in which a low voltage and a high current are output. Because the output current is relatively large, when the secondary-side winding includes the plurality of windings connected in parallel, each winding may split the output current, so that a current borne by each winding is not excessively large.

### Embodiment of Power Supply System

Based on the integrated magnetic component and the transformer that are provided in the foregoing embodiments, an embodiment of this application further provides a power system. The following describes the power system in detail with reference to the accompanying drawings.

FIG. 17 is a schematic diagram of a power system according to an embodiment of this application.

The power system provided in this embodiment includes a transformer 1702 described in the foregoing embodiment, and further includes a power conversion circuit 1701 and a rectifier circuit 1703.

A primary-side winding of the transformer 1702 is connected to the power conversion circuit 1701.

An implementation of the power conversion circuit 1701 is not specifically limited in this embodiment of this application, for example, the power conversion circuit 1701 may be a forward converter or a reverse converter that includes a controllable switch component.

A secondary-side winding of the transformer 1702 is connected to the rectifier circuit 1703.

In a possible implementation, the power system provided in this embodiment of this application may be applied to a power adapter of an electronic product, for example, a power adapter of a terminal device such as a mobile phone. The power system is particularly applicable to output of a low voltage and a large current. For example, an output large current may be used to quickly charge a battery of the mobile phone, to implement a quick charging function of the mobile phone.

The power system provided in this embodiment of this application includes the transformer provided in the foregoing embodiment, and the transformer includes the integrated magnetic component provided in the foregoing embodiment. Because in a manner of winding a PCB winding provided in this embodiment of this application, fractional turns can be wound on a single layer on a single magnetic pillar, odd-number turns of PCB windings can be evenly distributed on even-number layers. In addition, the integrated magnetic component in embodiments of this application includes a plurality of magnetic pillars. When there are more magnetic pillars, a thickness of the integrated magnetic component can be reduced, that is, a thickness of the transformer can be reduced, so that a thickness of the power system can be reduced. In particular, when the power system is applicable to a portable electronic product, a thickness or a volume of the portable electronic product can be reduced, and the electronic product is easy to carry, for example, a power adapter of a mobile phone.

It should be understood that, in this application, "at least one" means one or more, and "a plurality of" means two or more. The term "and/or" is used to describe an association relationship between associated objects, and indicates that three relationships may exist. For example, "A and/or B" may indicate the following three cases: Only A exists, only B exists, and both A and B exist, where A and B may be singular or plural. The character "/" usually indicates an "or" relationship between the associated objects. "At least one of the following items (pieces)" or a similar expression thereof indicates any combination of these items, including a single item (piece) or any combination of a plurality of items (pieces). For example, at least one (piece) of a, b, or c may represent: a, b, c, "a and b", "a and c", "b and c", or "a, b, and c", where a, b, and c may be singular or plural.

## Claims

1. An integrated magnetic component, comprising an integrated magnetic core and a PCB winding (40), wherein there are even-number layers of PCB windings; every two layers of PCB windings are one group, and each group of PCB windings comprises a first layer of PCB winding and a second layer of PCB winding;
the integrated magnetic core comprises M magnetic pillars (12, 22, 32, 42) that are symmetrically distributed, M is 2 or 4, and every two of the M magnetic pillars form one group; and
for each group of PCB windings, a current path on the first layer of PCB winding is connected to M paths on the first layer of PCB winding so that a sum of M currents on the M paths on the first layer of PCB winding is equal to a current on the current path on the first layer of PCB winding, and the current path on the first layer of PCB winding is connected to M paths on the second layer of PCB winding so that a sum of M currents on the M paths on the second layer of PCB winding is equal to the current on the current path on the first layer of PCB winding;
on each layer of PCB winding, the M paths run around the M magnetic pillars (12, 22, 32, 42) so that an i-th path of the M paths runs around an i-th magnetic pillar of the M magnetic pillars for i = 1, ..., M and forms a fractional turn;
for each group of PCB windings and for each group of magnetic pillars, on the first layer of PCB winding, after running around the two magnetic pillars of the respective group of magnetic pillars, the two respective paths of the M paths on the first layer of PCB winding are combined into one current, and the current obtained through combination flows around a first magnetic pillar (12, 32) in the respective group of magnetic pillars by N turns on the first layer of PCB winding, enters the second layer of PCB winding through a via hole (50), flows around the first magnetic pillar by N turns on the second layer of PCB winding, and is then divided into two respective paths of the M paths on the second layer of PCB winding; after running around the two magnetic pillars of the respective group of magnetic pillars, the two respective paths of the M paths on the second layer of PCB winding are combined into one current, the current obtained through combination flows around a second magnetic pillar (22, 42) of the respective group of magnetic pillars by N turns on the second layer of PCB winding, flows into the first layer of PCB winding through a via hole (50), and flows out after flowing around the second magnetic pillar by N turns on the first layer of PCB winding, and finally, for the case of M = 4, all current paths are combined, wherein N is a non-negative integer.

2. The component according to claim 1, wherein for each group of PCB windings, the M currents on the M paths on the first layer of PCB winding and the M currents on the M paths on the second layer of PCB winding have a same size.

3. The component according to any one of the preceding claims, wherein M is 2, the integrated magnetic core comprises a first side pillar (11), a first magnetic pillar (12), a second magnetic pillar (22), and a second side pillar (23), wherein the first side pillar, the first magnetic pillar, the second magnetic pillar, and the second side pillar are arranged side by side in this order;
a current direction in a PCB winding on the first magnetic pillar (12) and a current direction in a PCB winding on the second magnetic pillar (22) are opposite, so that magnetic flux of the first side pillar (11) and the second side pillar (23) is offset.

4. The component according to claim 3, wherein N+0.5 turns are wound on each layer of PCB winding (40) on each magnetic pillar (12, 22).

5. The component according to claim 3 or 4, wherein N is greater than zero, and for each group of PCB windings, the current flows in and flows out of a same layer of PCB winding (40):
the current flows into the first layer of PCB winding, and on the first layer of PCB winding, the current path is divided into two paths around the first magnetic pillar (12) and the second magnetic pillar (22), and after the two current paths obtained through division are combined, a current obtained through combination flows around the first magnetic pillar by N turns, and flows into the second layer of PCB winding through a via hole (50); and on the second layer of PCB winding, after the current flows around the first magnetic pillar by N turns, a current path is divided into two paths, and after the two current paths obtained through division are combined, a current obtained through combination flows around the second magnetic pillar by N turns, flows back to the first layer of PCB winding through a via hole (50), flows around the second magnetic pillar by N turns, and flows out of the first layer of PCB winding.

6. The component according to claim 1 or 2, wherein M is 2, N is zero, and for each group of PCB windings, the current flows into the first layer of PCB winding (40) and flows out of the second layer of PCB winding (40); and
the current flows into the first layer of PCB winding, and on the first layer of PCB winding, the current path is divided into two paths around the first magnetic pillar (12) and the second magnetic pillar (22); and after the two paths of currents obtained through division are converged, a current obtained through convergence is divided into two paths, and the two paths of currents obtained through division separately flow into the second layer of PCB winding through via holes (50), and on the second layer of PCB winding, the two currents obtained through division are converged, and a current obtained through convergence flows out of the second layer of PCB winding.

7. The component according to claim 1, wherein when M is 4, the integrated magnetic core comprises the following four magnetic pillars: a first magnetic pillar (12), a second magnetic pillar (22), a third magnetic pillar (32), and a fourth magnetic pillar (42), wherein the first magnetic pillar and the second magnetic pillar are one group, and the third magnetic pillar and the fourth magnetic pillar are one group;
the first magnetic pillar, the second magnetic pillar, the third magnetic pillar, and the fourth magnetic pillar are symmetrically distributed in a square; and
magnetic flux directions in any two adjacent magnetic pillars in the first magnetic pillar, the second magnetic pillar, the third magnetic pillar, and the fourth magnetic pillar are opposite.

8. The component according to claim 7, wherein for each group of PCB windings, the current flows into the first layer of PCB winding and flows out of the second layer of PCB winding:
the current flows into the first layer of PCB winding, and on the first layer of PCB winding, the current path is evenly divided into four paths around the four magnetic pillars, current paths around the first magnetic pillar (12) and the second magnetic pillar (22) flow into the second layer of PCB winding through via holes (50), current paths around the third magnetic pillar (32) and the fourth magnetic pillar (42) are combined and then divided into two paths, and the two paths of currents obtained through division flow into the second layer of PCB winding through via holes (50); and on the second layer of PCB winding, currents around the first magnetic pillar, the second magnetic pillar, the third magnetic pillar, and the fourth magnetic pillar are combined, and a current obtained through combination flows out of the second layer of PCB winding.

9. A transformer (1702), comprising the integrated magnetic component according to any one of claims 1 to 8, wherein the PCB winding of the integrated magnetic component is a primary-side winding of the transformer;
the transformer further comprises a secondary-side winding; and
the secondary-side winding comprises a plurality of layers of PCB windings; and
the layers of PCB windings in the primary-side winding and the plurality of layers of PCB windings in the secondary-side winding are wound on the integrated magnetic core in an interleaved manner.

10. The transformer (1702) according to claim 9, wherein one layer of PCB winding in the primary-side winding is wound on the integrated magnetic core, and one layer of PCB winding in the secondary-side winding is wound, and such a cycle continues.

11. The transformer (1702) according to claim 10, wherein a via hole is disposed between two adjacent layers of PCB windings in the primary-side winding, a via hole is disposed between two adjacent layers of PCB windings in the secondary-side winding, and the via hole is used to connect two adjacent layers of PCB windings in series or in parallel.

12. The transformer (1702) according to any one of claims 9 to 11, wherein the layers of PCB windings comprised in the primary-side winding are connected in series; and
the plurality of layers of PCB windings comprised in the secondary-side winding are connected in parallel.

13. A power system, comprising the transformer (1702) according to any one of claims 9 to 12, and further comprising a power conversion circuit (1701) and a rectifier circuit (1703), wherein
the primary-side winding of the transformer is connected to the power conversion circuit; and
the secondary-side winding of the transformer is connected to the rectifier circuit.

## Patentansprüche

1. Integrierte Magnetkomponente, die einen integrierten Magnetkern und eine PCB-Wicklung (40) umfasst, wobei es geradzahlige Schichten von PCB-Wicklungen gibt; alle zwei Schichten von PCB-Wicklungen eine Gruppe sind und jede Gruppe von PCB-Wicklungen eine erste Schicht der PCB-Wicklung und eine zweite Schicht der PCB-Wicklung umfasst;
der integrierte Magnetkern M Magnetsäulen (12, 22, 32, 42) umfasst, die symmetrisch verteilt sind, M 2 oder 4 ist und alle zwei der M Magnetsäulen eine Gruppe bilden; und für jede Gruppe von PCB-Wicklungen ein Strompfad auf der ersten Schicht der PCB-Wicklung mit M Pfaden auf der ersten Schicht der PCB-Wicklung so verbunden ist, dass eine Summe von M Strömen auf den M Pfaden auf der ersten Schicht der PCB-Wicklung gleich einem Strom auf dem Strompfad auf der ersten Schicht der PCB-Wicklung ist, und der Strompfad auf der ersten Schicht der PCB-Wicklung mit M Pfaden auf der zweiten Schicht der PCB-Wicklung so verbunden ist, dass eine Summe von M Strömen auf den M Pfaden auf der zweiten Schicht der PCB-Wicklung gleich dem Strom auf dem Strompfad auf der ersten Schicht der PCB-Wicklung ist;
auf jeder Schicht der PCB-Wicklung die M Pfade so um die M Magnetsäulen (12, 22, 32, 42) herum verlaufen, dass ein i-ter Pfad der M Pfade um eine i-te Magnetsäule der M Magnetsäulen für i = 1, ..., M herum verläuft und eine fraktionierte Windung bildet; für jede Gruppe von PCB-Wicklungen und für jede Gruppe von Magnetsäulen auf der ersten Schicht der PCB-Wicklung, nach dem Verlaufen um die zwei Magnetsäulen der jeweiligen Gruppe von Magnetsäulen herum, die zwei jeweiligen Pfade der M Pfade auf der ersten Schicht der PCB-Wicklung zu einem Strom kombiniert werden, und der Strom, der durch Kombination erhalten wird, um eine erste Magnetsäule (12, 32) in der jeweiligen Gruppe von Magnetsäulen herum durch N Windungen auf der ersten Schicht der PCB-Wicklung fließt, in die zweite Schicht der PCB-Wicklung durch ein Durchgangsloch (50) eintritt, um die erste Magnetsäule durch N Windungen auf der zweiten Schicht der PCB-Wicklung herum fließt, und dann in zwei jeweilige Pfade der M Pfade auf der zweiten Schicht der PCB-Wicklung geteilt wird; nach dem Verlaufen um die zwei Magnetsäulen der jeweiligen Gruppe von Magnetsäulen herum, die zwei jeweiligen Pfade der M Pfade auf der zweiten Schicht der PCB-Wicklung zu einem Strom kombiniert werden, wobei der Strom, der durch Kombination erhalten wird, um eine zweite Magnetsäule (22, 42) der jeweiligen Gruppe von Magnetsäulen herum durch N Windungen auf der zweiten Schicht der PCB-Wicklung fließt, in die erste Schicht der PCB-Wicklung durch ein Durchgangsloch (50) fließt und nach dem Fließen um die zweite Magnetsäule um N Windungen herum auf der ersten Schicht der PCB-Wicklung hinaus fließt, und schließlich für den Fall, dass M = 4, alle Strompfade kombiniert werden, wobei N eine nicht negative ganze Zahl ist.

2. Komponente nach Anspruch 1, wobei für jede Gruppe von PCB-Wicklungen die M Ströme auf den M Pfaden auf der ersten Schicht der PCB-Wicklung und die M Ströme auf den M Pfaden auf der zweiten Schicht der PCB-Wicklung eine gleiche Größe aufweisen.

3. Komponente nach einem der vorstehenden Ansprüche, wobei M 2 ist, der integrierte Magnetkern eine erste Seitensäule (11), eine erste Magnetsäule (12), eine zweite Magnetsäule (22) und eine zweite Seitensäule (23) umfasst, wobei die erste Seitensäule, die erste Magnetsäule, die zweite Magnetsäule und die zweite Seitensäule in dieser Reihenfolge nebeneinander angeordnet sind;
eine Stromrichtung in einer PCB-Wicklung auf der ersten Magnetsäule (12) und eine Stromrichtung in einer PCB-Wicklung auf der zweiten Magnetsäule (22) entgegengesetzt sind, sodass der Magnetfluss der ersten Seitensäule (11) und der zweiten Seitensäule (23) versetzt ist.

4. Komponente nach Anspruch 3, wobei N+0.5 Windungen auf jeder Schicht der PCB-Wicklung (40) auf jeder Magnetsäule (12, 22) gewickelt sind.

5. Komponente nach Anspruch 3 oder 4, wobei N größer als null ist und für jede Gruppe von PCB-Wicklungen der Strom in eine gleiche Schicht der PCB-Wicklung (40) und aus dieser hinaus fließt:
wobei der Strom in die erste Schicht der PCB-Wicklung fließt, und auf der ersten Schicht der PCB-Wicklung der Strompfad in zwei Pfade um die erste Magnetsäule (12) und die zweite Magnetsäule (22) herum geteilt ist, und nachdem die zwei Strompfade, die durch Teilung erhalten werden, kombiniert werden, ein Strompfad, der durch Kombination erhalten wird, um die erste Magnetsäule um N Windungen herum fließt und in die zweite Schicht der PCB-Wicklung durch ein Durchgangsloch (50) fließt; und
auf der zweiten Schicht der PCB-Wicklung, nachdem der Strom um die erste Magnetsäule um N Windungen herum fließt, ein Strompfad in zwei Pfade unterteilt wird, und nachdem die zwei Strompfade, die durch die Teilung erhalten werden, kombiniert werden, ein Strom, der durch die Kombination erhalten wird, um die zweite Magnetsäule um N Windungen herum fließt, zurück zu der ersten Schicht der PCB-Wicklung durch ein Durchgangsloch (50) fließt, um die zweite Magnetsäule um N Windungen herum fließt und aus der ersten Schicht der PCB-Wicklung heraus fließt.

6. Komponente nach Anspruch 1 oder 2, wobei M 2 ist, N null ist und für jede Gruppe von PCB-Wicklungen der Strom in die erste Schicht der PCB-Wicklung (40) fließt und aus der zweiten Schicht der PCB-Wicklung (40) hinaus fließt; und
der Strom in die erste Schicht der PCB-Wicklung fließt und auf der ersten Schicht der PCB-Wicklung der Strompfad in zwei Pfade um die erste Magnetsäule (12) und die zweite Magnetsäule (22) herum geteilt ist; und nachdem die zwei Pfade von Strömen, die durch die Teilung erhalten werden, konvergiert sind, ein Strom, der durch Konvergenz erhalten wird, in zwei Pfade geteilt ist, und die zwei Pfade von Strömen, die durch Teilung erhalten werden, in die zweite Schicht der PCB-Wicklung durch die Durchgangslöcher (50) getrennt fließen, und auf der zweiten Schicht der PCB-Wicklung, die zwei Ströme, die durch Teilung erhalten werden, konvergiert sind, und ein Strom, der durch Konvergenz erhalten wird, aus der zweiten Schicht der PCB-Wicklung hinaus fließt.

7. Komponente nach Anspruch 1, wobei, wenn M 4 ist, der integrierte Magnetkern die folgenden vier Magnetsäulen umfasst: eine erste Magnetsäule (12), eine zweite Magnetsäule (22), eine dritte Magnetsäule (32) und eine vierte Magnetsäule (42), wobei die erste Magnetsäule und die zweite Magnetsäule eine Gruppe sind und die dritte Magnetsäule und die vierte Magnetsäule eine Gruppe sind;
die erste Magnetsäule, die zweite Magnetsäule, die dritte Magnetsäule und die vierte Magnetsäule in einem Quadrat symmetrisch verteilt sind; und
magnetische Flussrichtungen in beliebigen zwei angrenzenden Magnetsäulen in der ersten Magnetsäule, der zweiten Magnetsäule, der dritten Magnetsäule und der vierten Magnetsäule entgegengesetzt sind.

8. Komponente nach Anspruch 7, wobei für jede Gruppe von PCB-Wicklungen der Strom in die erste Schicht der PCB-Wicklung fließt und aus der zweiten Schicht der PCB-Wicklung hinaus fließt:
wobei der Strom in die erste Schicht der PCB-Wicklung fließt und auf der ersten Schicht der PCB-Wicklung, der Strompfad gleichmäßig in vier Pfade um die vier Magnetsäulen herum geteilt ist, Strompfade um die erste Magnetsäule (12) und die zweite Magnetsäule (22) herum in die zweite Schicht der PCB-Wicklung durch Durchgangslöcher (50) fließen, Strompfade um die dritte Magnetsäule (32) und die vierte Magnetsäule (42) herum kombiniert und dann in zwei Pfade geteilt werden, und die zwei Pfade von Strömen, die durch die Teilung erhalten werden, in die zweite Schicht der PCB-Wicklung durch Durchgangslöcher (50) fließen; und auf der zweiten Schicht der PCB-Wicklung Ströme um die erste Magnetsäule, die zweite Magnetsäule, die dritte Magnetsäule und die vierte Magnetsäule herum kombiniert werden, und ein Strom, der durch Kombination erhalten wird, aus der zweiten Schicht der PCB-Wicklung hinaus fließt.

9. Transformator (1702), der die integrierte Magnetkomponente nach einem der Ansprüche 1 bis 8 umfasst, wobei die PCB-Wicklung der integrierten Magnetkomponente eine primärseitige Wicklung des Transformators ist;
der Transformator ferner eine sekundärseitige Wicklung umfasst; und
die sekundärseitige Wicklung eine Vielzahl von Schichten von PCB-Wicklungen umfasst; und
die Schichten der PCB-Wicklungen in der primärseitigen Wicklung und die Vielzahl von Schichten der PCB-Wicklungen in der sekundärseitigen Wicklung in einer verschachtelten Weise auf dem integrierten Magnetkern gewickelt sind.

10. Transformator (1702) nach Anspruch 9, wobei eine Schicht der PCB-Wicklung in der primärseitigen Wicklung auf dem integrierten Magnetkern gewickelt ist und eine Schicht der PCB-Wicklung in der sekundärseitigen Wicklung gewickelt ist und ein solcher Zyklus fortgesetzt wird.

11. Transformator (1702) nach Anspruch 10, wobei ein Durchgangsloch zwischen zwei angrenzenden Schichten von PCB-Wicklungen in der primärseitigen Wicklung eingerichtet ist, ein Durchgangsloch zwischen zwei angrenzenden Schichten von PCB-Wicklungen in der sekundärseitigen Wicklung eingerichtet ist, und das Durchgangsloch verwendet wird, um zwei angrenzende Schichten von PCB-Wicklungen in Reihe oder parallel zu schalten.

12. Transformator (1702) nach einem der Ansprüche 9 bis 11, wobei die Schichten der PCB-Wicklungen, die in der primärseitigen Wicklung umfasst sind, in Reihe geschaltet sind; und
die Vielzahl von Schichten der PCB-Wicklungen, die in der sekundärseitigen Wicklung umfasst sind, parallel geschaltet sind.

13. Leistungssystem, das den Transformator (1702) nach einem der Ansprüche 9 bis 12 umfasst und das ferner eine Leistungswandlungsschaltung (1701) und eine Gleichrichterschaltung (1703) umfasst, wobei
die primärseitige Wicklung des Transformators mit der Leistungswandlungsschaltung verbunden ist; und
die sekundärseitige Wicklung des Transformators mit der Gleichrichterschaltung verbunden ist.

## Revendications

1. Composant magnétique intégré, comprenant un noyau magnétique intégré et un enroulement PCB (40), dans lequel il y a des couches paires d'enroulements de PCB ; toutes les deux couches d'enroulements PCB sont un groupe, et chaque groupe d'enroulements PCB comprend une première couche d'enroulement PCB et une seconde couche d'enroulement PCB ;
le noyau magnétique intégré comprend M piliers magnétiques (12, 22, 32, 42) répartis symétriquement, M vaut 2 ou 4, et tous deux des M piliers magnétiques forment un groupe ; et
pour chaque groupe d'enroulements PCB, un chemin de courant sur la première couche d'enroulement PCB est connecté à M chemins sur la première couche d'enroulement PCB de sorte qu'une somme de M courants sur les M chemins sur la première couche d'enroulement PCB est égale à un courant sur le chemin courant sur la première couche d'enroulement PCB, et le chemin courant sur la première couche d'enroulement PCB est connecté à M chemins sur la seconde couche d'enroulement PCB de sorte qu'une somme de M courants sur les M chemins sur la seconde couche d'enroulement PCB est égale au courant sur le chemin courant sur la première couche d'enroulement PCB ;
sur chaque couche d'enroulement de PCB, les M chemins s'exécutent autour des M piliers magnétiques (12, 22, 32, 42) de sorte qu'un i-ème chemin des M chemins s'étend autour d'un i-ème pilier magnétique des M piliers magnétiques pour i = 1,.., M et forme une rotation fractionnaire ;
pour chaque groupe d'enroulements de PCB et pour chaque groupe de piliers magnétiques, sur la première couche d'enroulement de PCB, après l'exécution autour des deux piliers magnétiques du groupe respectif de piliers magnétiques, les deux chemins respectifs des M chemins sur la première couche d'enroulement de PCB sont combinés en un courant, et le courant obtenu par combinaison s'écoule autour d'un premier pilier magnétique (12, 32) dans le groupe respectif de piliers magnétiques par N spires sur la première couche d'enroulement de PCB, entre dans la seconde couche d'enroulement de PCB à travers un trou d'interconnexion (50), s'écoule autour du premier pilier magnétique par N spires sur la seconde couche d'enroulement de PCB, et est ensuite divisée en deux chemins respectifs des M chemins sur la seconde couche d'enroulement de PCB ; après le roulage autour des deux piliers magnétiques du groupe respectif de piliers magnétiques, les deux chemins respectifs des M chemins sur la seconde couche d'enroulements de PCB sont combinés en un courant, le courant obtenu par combinaison s'écoule autour d'un deuxième pilier magnétique (22, 42) du groupe respectif de piliers magnétiques par N spires sur la seconde couche d'enroulements de PCB, s'écoule dans la première couche d'enroulement de PCB à travers un trou d'interconnexion (50), et s'écoule après l'écoulement autour du deuxième pilier magnétique par N spires sur la première couche d'enroulements de PCB, et enfin, pour le cas de M = 4, tous les chemins de courant sont combinés, dans lequel N est un entier non négatif.

2. Composant selon la revendication 1, dans lequel pour chaque groupe d'enroulements PCB, les M courants sur les M chemins sur la première couche d'enroulement PCB et les M courants sur les M chemins sur la seconde couche d'enroulement PCB ont une même taille.

3. Composant selon l'une quelconque des revendications précédentes, dans lequel M est 2, le noyau magnétique intégré comprend un premier pilier latéral (11), un premier pilier magnétique (12), un deuxième pilier magnétique (22) et un second pilier latéral (23), dans lequel le premier pilier latéral, le premier pilier magnétique, le deuxième pilier magnétique et le second pilier latéral sont agencés côte à côte dans cet ordre ;
une direction de courant dans un enroulement de PCB sur le premier pilier magnétique (12) et une direction de courant dans un enroulement de PCB sur le deuxième pilier magnétique (22) sont opposées, de sorte que le flux magnétique du premier pilier latéral (11) et du second pilier latéral (23) est décalé.

4. Composant selon la revendication 3, dans lequel N+0,5 spires sont enroulées sur chaque couche d'enroulement PCB (40) sur chaque pilier magnétique (12, 22).

5. Composant selon la revendication 3 ou 4, dans lequel N est supérieur à zéro, et pour chaque groupe d'enroulements de PCB, le courant circule dans et s'écoule d'une même couche d'enroulement de PCB (40) :
le courant circule dans la première couche d'enroulement de PCB, et sur la première couche d'enroulement de PCB, le chemin de courant est divisé en deux chemins autour du premier pilier magnétique (12) et du deuxième pilier magnétique (22), et après que les deux chemins de courant obtenus par division sont combinés, un courant obtenu par combinaison s'écoule autour du premier pilier magnétique par N spires, et s'écoule dans la seconde couche d'enroulement de PCB à travers un trou d'interconnexion (50) ; et sur la seconde couche d'enroulement PCB, après que le courant circule autour du premier pilier magnétique par N spires, un chemin de courant est divisé en deux chemins, et après que les deux chemins de courant obtenus par division sont combinés, un courant obtenu par combinaison circule autour du deuxième pilier magnétique par N spires, retourne à la première couche d'enroulement PCB au travers d'un trou d'interconnexion (50), s'écoule autour du deuxième pilier magnétique par N spires, et s'écoule de la première couche d'enroulement PCB.

6. Composant selon la revendication 1 ou 2, dans lequel M vaut 2, N est zéro, et pour chaque groupe d'enroulements de PCB, le courant s'écoule dans la première couche d'enroulement de PCB (40) et s'écoule de la seconde couche d'enroulement de PCB (40) ; et
le courant circule dans la première couche d'enroulement de PCB, et sur la première couche d'enroulement de PCB, le chemin de courant est divisé en deux chemins autour du premier pilier magnétique (12) et du deuxième pilier magnétique (22) ; et après que les deux chemins de courants obtenus par division sont convergents, un courant obtenu par convergence est divisé en deux chemins, et les deux chemins de courants obtenus par division s'écoulent séparément dans la seconde couche d'enroulement PCB au travers de trous d'interconnexion (50), et sur la seconde couche d'enroulement PCB, les deux courants obtenus par division sont convergents, et un courant obtenu par rapprochement des flux de la seconde couche d'enroulement PCB.

7. Composant selon la revendication 1, dans lequel lorsque M est 4, le noyau magnétique intégré comprend les quatre piliers magnétiques suivants : un premier pilier magnétique (12), un deuxième pilier magnétique (22), un troisième pilier magnétique (32) et un quatrième pilier magnétique (42), dans lequel le premier pilier magnétique et le deuxième pilier magnétique sont un groupe, et le troisième pilier magnétique et le quatrième pilier magnétique sont un groupe ;
le premier pilier magnétique, le deuxième pilier magnétique, le troisième pilier magnétique et le quatrième pilier magnétique sont répartis symétriquement dans un carré ; et
des directions de flux magnétique dans deux piliers magnétiques adjacents quelconques dans le premier pilier magnétique, le deuxième pilier magnétique, le troisième pilier magnétique et le quatrième pilier magnétique sont opposés.

8. Composant selon la revendication 7, dans lequel pour chaque groupe d'enroulements de PCB, le courant s'écoule dans la première couche d'enroulements de PCB et s'écoule hors de la seconde couche d'enroulement ;
le courant circule dans la première couche d'enroulement de PCB, et sur la première couche d'enroulement de PCB, le chemin de courant est uniformément divisé en quatre chemins autour des quatre piliers magnétiques, des chemins de courant autour du premier pilier magnétique (12) et du deuxième pilier magnétique (22) s'écoulant dans la seconde couche d'enroulement de PCB au travers de trous d'interconnexion (50), des chemins de courant autour du troisième pilier magnétique (32) et du quatrième pilier magnétique (42) sont combinés puis divisés en deux chemins, et les deux chemins de courants obtenus à travers un écoulement de division dans la seconde couche d'enroulement de PCB au travers de trous d'interconnexion (50) ; et sur la seconde couche d'enroulement PCB, des courants autour du premier pilier magnétique, du deuxième pilier magnétique, du troisième pilier magnétique et du quatrième pilier magnétique sont combinés, et un courant obtenu par combinaison s'écoule de la seconde couche d'enroulement PCB.

9. Transformateur (1702), comprenant le composant magnétique intégré selon l'une quelconque des revendications 1 à 8, dans lequel l'enroulement de PCB du composant magnétique intégré est un enroulement côté primaire du transformateur ;
le transformateur comprend en outre un enroulement côté secondaire ; et
l'enroulement côté secondaire comprend une pluralité de couches d'enroulements de PCB ; et
les couches d'enroulements de PCB dans l'enroulement côté primaire et la pluralité de couches d'enroulements de PCB dans l'enroulement côté secondaire sont enroulées sur le noyau magnétique intégré d'une manière entrelacée.

10. Transformateur (1702) selon la revendication 9, dans lequel une couche d'enroulement de PCB dans l'enroulement côté primaire est enroulée sur le noyau magnétique intégré, et une couche d'enroulement PCB dans l'enroulement côté secondaire est enroulée, et un tel cycle continue.

11. Transformateur (1702) selon la revendication 10, dans lequel un trou d'interconnexion est disposé entre deux couches adjacentes d'enroulements de PCB dans l'enroulement côté primaire, un trou d'interconnexion est disposé entre deux couches adjacentes d'enroulements de PCB dans l'enroulement côté secondaire, et le trou d'interconnexion est utilisé pour connecter deux couches adjacentes d'enroulements de PCB en série ou en parallèle.

12. Transformateur (1702) selon l'une quelconque des revendications 9 à 11, dans lequel les couches d'enroulements de PCB comprises dans l'enroulement côté primaire sont connectées en série ; et
la pluralité de couches d'enroulements de PCB comprises dans l'enroulement côté secondaire sont connectées en parallèle.

13. Système d'alimentation, comprenant le transformateur (1702) selon l'une quelconque des revendications 9 à 12, et comprenant en outre un circuit de conversion de puissance (1701) et un circuit redresseur (1703), dans lequel
l'enroulement côté primaire du transformateur est connecté au circuit de conversion de puissance ; et
l'enroulement côté secondaire du transformateur est connecté au circuit redresseur.
